# EUROPEAN PATENT APPLICATION

(11) **EP 1 681 017 A1**
(43) Date of publication of application: **19.07.2006**
(21) Application number: 05000582.6
(22) Date of filing: 13.01.2005
(51) Int. Cl.: A61B 5/055

(54) **Implantable chamber, imaging method and magnetic resonance imaging system**

(71) Applicant: DKFZ Deutsches Krebsforschungszentrum, 69120 Heidelberg (DE)
(72) Inventor: Bock, Michael, 69115 Heidelberg (DE); Umathum, Reiner, 69115 Heidelberg (DE); Kiessling, Fabian, 69120 Heidelberg (DE); Fusenig, Norbert, 69118 Heidelberg (DE); Müller, Margaretha, 69221 Dossenheim (DE)
(74) Representative: Huhn, Michael

(57) **Abstract**

The present invention relates to an implantable chamber (1) with a connecting element (2), comprising a connecting sleeve (6) and a surrounding contact surface (7), an insert element (3), comprising an insert sleeve (8) and a surrounding abutment surface (9). The insert sleeve (8) is inserted into the connecting sleeve (6) of the connecting element (2). The implantable chamber (1) further comprises a cap (4) with a surrounding edge (11), the cap (4) partly covering the connecting element (2) and the insert element (3), leaving an opening (13) on one side. The implantable chamber (1) contains a passive resonance circuit (14) with an inductance and a capacitance, the passive resonance circuit (14) surrounding at least part of a cavity (15) inside the insert element (3).

## Description

The present invention relates to an implantable chamber, an imaging method and a magnetic resonance imaging system. The present invention relates more particularly to an implantable chamber with a passive resonance circuit and an imaging method for imaging an object within a cavity inside of the implantable chamber.

Magnetic resonance imaging processes are well known in the state of the art. Magnetic resonance imaging' apparatuses obtain a tomographic image of an object under examination. Therefore, the object is placed in a homogenous static magnetic field. This static magnetic field defines an equilibrium axis of magnetic alignment. Furthermore, one or more gradient magnetic fields, which are imposed on the static magnetic field, are applied to the object in order to obtain a spatially-dependent magnetic field. A radio frequency field is then applied to the object under examination in a direction orthogonal to the static magnetic field direction to excite magnetic resonance in a material of the object, typically in hydrogen nuclei, the resulting radio frequency signals being detected. From these detected radio frequency signals an image of the object is reconstructed.

Implantable chambers are known in the state of the art, for example so-called skin windows. They are implanted at least partly under the skin of an animal for examining biological processes taking place between an object within the implanted chamber and the animal tissue. Therefore, the object and the animal tissue are in direct contact across an opening of the chamber. One possible application of such an implanted chamber is bringing cells into contact with normal tissue of an animal across a membrane to study the generation of vessels.

The object inside of the implantable chamber can be studied by magnetic resonance imaging. The magnetic resonance imaging of the inside of small devices which are implanted under the skin of an animal with a high resolution is a problem in the state of the art. The radio frequency receiving coils of the magnetic resonance imaging apparatus are usually placed outside of the animal body, so that not only the region of interest within the small device is imaged, but also a great part of its surrounding tissue. Therefore, the signal to noise ratio is not high enough in the region of interest. Small structures, which may be essential for the result of a study, lie under the limit of resolution and are therefore not visible.

It has been proposed in the state of the art to implant the radio frequency receiving coils inside the animal. These implanted coils needed a connection from the animal to the magnetic resonance imaging apparatus, so that wires were running from inside to outside the animal, representing a major inconvenience to both the animal and the spectroscopist as well as a cause for chronic infection.

M. D. Schnall et al. propose in "Wireless Implanted Magnetic Resonance Probes for in Vivo NMR" (J. Magn. Reson. 68, 161-167 (1986)) to study internal organs of an animal in vivo using a wireless implantable magnetic resonance probe, that is inductively coupled to the spectrometer and can be tuned and matched remotely.

In the state of the art it is known to determine the position of an object placed in a region of a body using a closed loop tuned coil arrangement or a resonance circuit, which is attached to the object.

US-B1 6,317,091 is directed to an apparatus for inductively coupling a nuclear magnetic resonance signal into a reception antenna having a resonant coil arrangement. Such an apparatus is connected to a medical intervention instrument, so that the intervention instrument can be well-localized, independently of its alignment, using nuclear magnetic resonance technology.

US 5,819,737 refers to a method of locating the position of an object placed in the region of a body being examined, using a magnetic resonance technique, a closed loop tuned coil arrangement being attached to the object.

US-B1 6,280,385 is directed to a magnetic resonance imaging process for the imaging and determination of the position of a stent introduced into an examination object. In this process the examination object is placed in a magnetic field, the examination object having a stent with at least one passive resonance circuit disposed therein. Then a high frequency radiation of a specific resonance frequency is applied to the examination object such that transitions between spin energy levels of atomic nuclei of the examination object are excited. The magnetic resonance signals thus produced are detected as signal responses by a receiving coil and the detected signal responses are imaged. In a locally defined area proximate the stent, a changed signal response is produced by the at least one passive resonance circuit of the stent, the passive resonance circuit comprising an inductor and a capacitor forming a closed-loop coil arrangement such that the resonance frequency of the passive resonance circuit is essentially equal to the resonance frequency of the applied high-frequency radiation and such that the area is imaged using the changed signal response.

The object of the present invention is to provide an implantable chamber, an imaging method and a magnetic resonance imaging system for the imaging of an object in a cavity within an implantable chamber, producing images of the object with a high resolution.

This and other objects are achieved by the present invention, which comprises an implantable chamber with a connecting element, comprising a connecting sleeve and a surrounding contact surface, an insert element, comprising an insert sleeve and a surrounding abutment surface, the insert sleeve being inserted into the connecting sleeve of the connecting element, and a cap with a surrounding edge, the cap partly covering the connecting element and the inserted insert element, leaving an opening on one side. This implantable chamber contains a passive resonance circuit with an inductance and a capacitance, the passive resonance circuit surrounding at least part of a cavity inside the insert element.

When this implantable chamber is at least partly implanted under the skin of an animal, an object which is positioned in the cavity inside of the insert element can interact with the surrounding tissue of the animal via the opening.

The passive resonance circuit needs no connecting wires to the outside, when the chamber is implanted under the skin of an animal. The resonance frequency of the passive resonance circuit is preferably essentially equal to the frequency of the applied high-frequency radiation of a magnetic resonance imaging system. With the help of the passive resonance circuit the resolution of a magnetic resonance image of an object within the cavity is enhanced. The resonance circuit is excited by the application of the radio frequency field within a magnetic resonance imaging apparatus, the magnetic resonance signal inside of the inductance of the resonance circuit being amplified. The inductance and the capacitance of the resonance circuit are particularly selected, so that the resonance magnification of the radio frequency field provided by the magnetic resonance imaging apparatus can be used to suppress the signals coming from the surrounding material of the implantable chamber. The amplified signal from within the chamber can be detected by a radio frequency receiving coil of the magnetic resonance imaging apparatus with a high signal to noise ratio. The high spatial resolution of the gained image from within the implantable chamber allows the visualization of small structure inside of the cavity, for example blood vessels, in a short measuring time, for example in a couple of 10 minutes. The magnetic resonance imaging of the chamber's interior can be repeated many times during days or weeks. Therefore, long term studies, for example of neoangiogenesis, can be carried out with the implantable chamber according to the present invention.

The implantable chamber comprises three elements: the connecting element, the insert element and the cap. In a preferred embodiment of the present invention, these three elements have a circular cross-section, the contact surface, the abutment surface and the edge being annular. Preferably the contact surface, the abutment surface and the edge protrude perpendicularly from one end of the connecting sleeve, the insert sleeve and the cap, respectively. The three elements are plugged together, the cap covering the implantable chamber, but leaving one side open. Preferably the chamber can easily be separated into individual components. A preferred embodiment of the present invention provides that the opening merges into the cavity within the insert sleeve of the insert element. The cavity inside the insert element thus is in contact with the surrounding of the chamber via the opening on one side.

The cap of the chamber is preferably made of silicon or any other bio-compatible flexible material. For additional optical measurements, the cap can be manufactured with a transparency in the desired optical range (e.g. near infrared), which is sufficiently high. The connecting element and the insert element are preferably made of an MR-compatible material (i.e. non-magnetic and not electrically conducting) such as Teflon to reduce artefacts during magnetic resonance imaging.

One embodiment of the present invention provides that the abutment surface of the inserted insert element abuts one end of the connecting sleeve of the connecting element and the surrounding edge of the cap abuts the contact surface of the covered connecting element.

The implantable chamber according to the invention can contain a removable cover element to cover the opening. This cover element can be used to cover one side of the assembled connecting element and insert element. The cavity in the insert element can then be filled with an object under examination from one side of the insert element, opposite to the side covered with the cover element. The cover element keeps this object from leaving the cavity on the side of the cover element. Before the chamber is implanted, the other side of the assembled connecting element and insert element is covered by the cap and the cover element is removed, so that the object can interact with the surrounding of the chamber via the resulting opening.

The cover element can be for example a flexible foil, being secured between the connecting sleeve and the insert sleeve. This foil can cover the whole of one side of the insert sleeve or only an annular area around the outside of the opening. The flexible foil can be secured between the connecting sleeve and the insert sleeve by squeezing its outer part between the two sleeves when the insert element is plugged into the connecting element. The cover element can also be any other kind of cover known by those skilled in the art.

According to a preferred embodiment of the present invention the cap of the implantable chamber is at least partly transparent. This is especially advantageous, if the object in the implantable chamber is not only to be studied by means of magnetic resonance imaging, but also by one or more optical imaging methods. The optical imaging method can for example be based on the detection of fluorescence or NIR-radiation, which can be transmitted through the transparent cap and then be detected.

Furthermore, the cap has an upper area, which can be flat or curved, depending on the intended use of the implantable chamber.

According to a preferred embodiment of the present invention, the inductance is a coil, which is wound around the insert sleeve or the connecting sleeve. Preferably, the turns of the coil, which is wound around one of the sleeves, lie substantially in parallel plains. The coil can be a flexible printed circuit.

The capacitance of the resonance circuit can for example be a capacitor attached to the coil or it can be the capacitance of the coil itself.

A preferred embodiment of the present invention provides that the capacitance and the inductance are placed in a recess within the insert sleeve, the connecting sleeve or the cap. For example the insert sleeve of the insert element can be provided with a circumferential groove on its outside to accommodate the resonance circuit. When the resonance circuit is placed within the groove, the insert element can easily be assembled with the connecting element, the insert sleeve gliding smoothly into the connecting sleeve, without damaging the resonance circuit.

According to a preferred embodiment of the present invention, the implantable chamber comprises at least one marker, which can be imaged by an imaging system and which allows the alignment of the chamber within the imaging system. The chamber can be implanted at least partly under the skin of an animal and an object inside of the chamber can be imaged by successively taking several images (e.g. magnetic resonance images) with certain time gaps in between the taking of the images. The at least one marker is needed to guarantee an unchanged alignment of the object for each image, even after a time gap of days or weeks. Thus it can be achieved, that with repeated imaging of an animal, always an image at the same (slice) position of the imaged object is produced. The marker has to be made of a material which the used imaging system is able to detect. The marker can for example be a hollow space filled with liquid or an appendix of the connecting element or of the insert element. The alignment of the chamber using the marker can be achieved with reference to one plain surface of the implantable chamber (for example at the bottom side of the chamber, parallel to the surrounding edge) and to the orientation of the marker in relation to the plain surface. Another possibility is the marker being designed so that its image can be unambiguously assigned to one orientation of the implantable chamber.

One embodiment of the present invention provides, that the implantable chamber comprises a fastener for immobilizing the chamber during an application of an imaging method. The fastener can be some kind of hook, which immobilizes the implanted chamber in the body of the animal. The fastener can at the same time be a fixing element, which connects for example the chamber to a radio frequency conceiving coil of a magnetic resonance imaging apparatus (which is positioned outside of the animal), in order to align the chamber and the coil to one another and to immobilize these two components in this position. Therefore, movement artefacts during the examination can be avoided.

According to one embodiment of the present invention, the cavity inside the insert sleeve contains an object, the object comprising a separating layer of a medium, which covers the opening of the cavity and at least one further layer of biological material. The separating layer of a medium can e.g. be a collagen or fibronectin gel matrix. Above the separating layer, target cells such as tumour or epithelial cells can be cultivated. The layer directs the mutual infiltration of host animal cells and target cells, which simplifies the study of their growth. Furthermore, the gel matrix acts as a spacer providing a distinct separation between host and implanted target cells. Proliferating stromal host tissue including vessels and infiltrating tumour tissue crosses the gel matrix from both sides, and proliferating tumour stroma and angiogenic regions can be better separated.

The present invention further refers to an imaging method for the imaging of an object inside of an implantable chamber according to the present invention, the chamber containing a passive resonance circuit with a resonance frequency, the method comprising the steps of:
- producing and detecting magnetic resonance signals by
   - placing the chamber within a magnetic field and by
   - applying high frequency radiation with a frequency being essentially equal to the resonance frequency of the passive resonance circuit, and
- reconstructing an image of the object from the detected magnetic resonance signals.

The imaging method according to the invention has the advantage of a high signal to noise ratio of the images taken of an object inside of the implantable chamber. This region of interest can be imaged with a high quality, suppressing signals from the surrounding of the chamber by means of exciting the resonance circuit with the high frequency radiation, applied by a transmitting coil arrangement of a magnetic resonance imaging apparatus. The magnetic resonance signals can be detected by means of the radio frequency receiving coil arrangement of the magnetic resonance imaging apparatus. Possible image reconstruction methods are known to those skilled in the art.

According to one embodiment of the present invention the imaging method combines magnetic resonance imaging with an optical imaging method for imaging the object. Possible optical imaging methods are near infrared imaging of "smart" contrast agents, which specifically bind to cellular targets. Further applications are the tracking of labelled cells (e.g. after labelling with quantum dots or after transformation of cells with fluorescence proteins) and the use of unspecific optical dyes in order to assess and quantify parameters of tissue vascularisation. For these purposes usually CCD-cameras, optical tomographs or intravital (fluorescence) microscopes are used.

One embodiment of the present invention provides an imaging method, wherein the chamber is implanted at least partly under the skin of an animal and the object inside of the chamber is imaged be successively taking several images with certain time gaps in between the taking of the images. The implantable chamber according to the invention can be implanted only partly under the skin of an animal, e.g. in such a manner, that the skin surrounds the cap, only covering its surrounding edge. In this case the upper part of the cap projects out of the skin of the animal. For other applications, the implantable chamber can be fully implanted under the skin of an animal, the skin covering the whole cap of the chamber.

By successively taking several images of the object in the chamber with certain time gaps (e.g. of seconds, minutes, hours, days or weeks) in between the taking of the images, the development of the object in the course of time can be observed.

Preferably the chamber is aligned by using at least one marker, which is integrated into the chamber, in order to assure an unchanged alignment of the object for each of the several images. The function of the marker has been explained above.

According to a preferred embodiment of the present invention, several objects, each of which is placed within a chamber, are imaged simultaneously, each chamber implanted at least partly under the skin of a different animal. This permits the examination of two or more animals at the same time, having the advantage of reducing the measurement time and therefore the costs of the study. High quality images of all of the objects inside the different implantable chambers can be produced at the same time.

The present invention is further directed to a magnetic resonance imaging system comprising
• at least two implantable chambers according to the present invention and
• a magnetic resonance imaging apparatus, including an electromagnet to produce a uniform static magnetic field, a gradient coil arrangement, whereby a gradient may be imposed on the static magnetic field, a radio frequency coil system with a transmitting coil arrangement to apply a radio frequency field to the chambers to be imaged and with a radio frequency receiving coil arrangement, arranged to detect radio frequency signals resulting from magnetic resonance excited in the object within the chambers, the receiving coil arrangement comprising at least one receiving coil for each chamber being aligned for receiving the radio frequency signals resulting from the object within this chamber.

With this magnetic resonance imaging system two or more animals with implanted chambers can be examined at the same time, each receiving coil receiving the magnetic resonance signal from the interior of one special chamber to which it is aligned.

The receiving coils can be aligned with the chambers by at least one fixing element which is connected to the receiving coils and to the chambers. The function of the fixing element has been explained above.

The implantable chamber in accordance with the present invention will now be described by way of example with reference to the accompanying drawing in which
Figure 1 is a schematic design of one embodiment of the implantable chamber according to the present invention, represented in section,
Figure 2 is a schematic view of the interior of another embodiment of the implantable chamber according to the present invention which contains a marker and
Figure 3 is a schematic 3D-view of the interior of another embodiment of the implantable chamber according to the present invention which contains a marker.

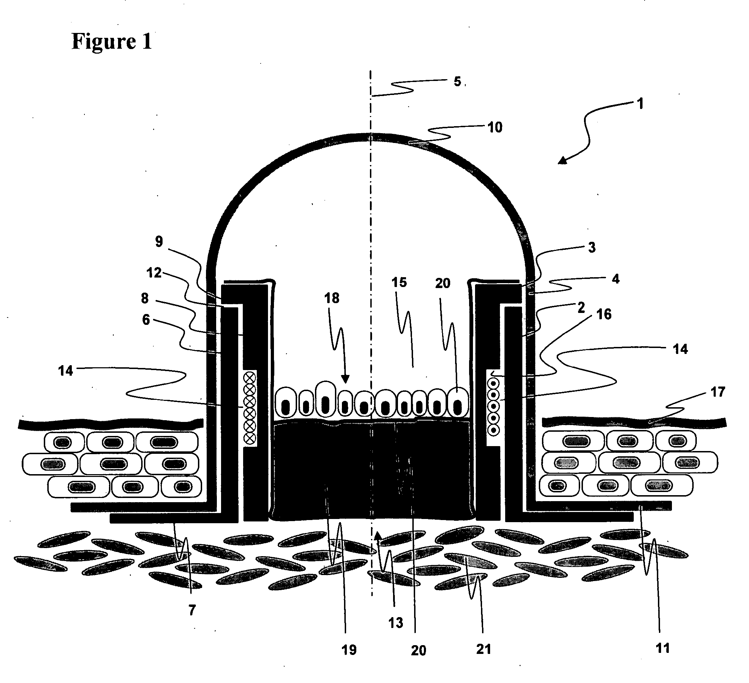

In Figure 1 the implantable chamber 1 comprises a connecting element 2, an insert element 3 and a cap 4. The implantable chamber 1 is rotationally symmetric referring to the symmetry line 5. The connecting element 2 comprises a connecting sleeve 6 and a surrounding contact surface 7. The insert element 3 comprises an insert sleeve 8 and a surrounding abutment surface 9. The cap 4 has an upper part 10, which is curved, and a surrounding edge 11. In this assembled condition of the chamber 1 as shown in Figure 1, the abutment surface 9 of the insert element 3 abuts one end 12 of the connecting sleeve 6. Furthermore, the surrounding edge 11 of the cap 4 abuts the contact surface 7 of the connecting element 2. The cap 4 covers the assembled connecting element 2 and insert element 3, leaving an opening 13 on one side.

The implantable chamber 1 also contains a passive resonance circuit 14. The passive resonance circuit 14 surrounds part of the cavity 15 inside of the insert element 3. The inductance of the resonance circuit 14 as shown in Figure 1 can be a coil, which is wound around the insert sleeve 8 with a small capacitor (not shown) attached to the coil. The capacitance and the inductance are placed in a recess 16 within the insert sleeve 8.

The implantable chamber 1 as shown in Figure 1 is implanted partly under the skin 17 of an animal (e.g. a mouse), the skin 17 surrounding the cap 4 and covering the surrounding edge 11. The cavity 15 contains an object 18. The object 18 comprises a separating layer 1'9 of collagen, which covers the opening 13 of the cavity 15. Furthermore, the object 18 comprises a further layer 20 of cells. Via the opening 13 the object 18 is in contact with the tissue 21 under the skin 17 of the animal (e.g. mouse mesenchyme), since the opening 13 merges into the cavity 15 in the insert sleeve 8 of the insert element 3.

By means of the resonance circuit 14 an enhanced image of the object 18 inside of the implantable chamber 1 can be produced with a magnetic resonance imaging apparatus, by tuning the resonance frequency of the resonance circuit 14 to the high frequency radiation of the apparatus.

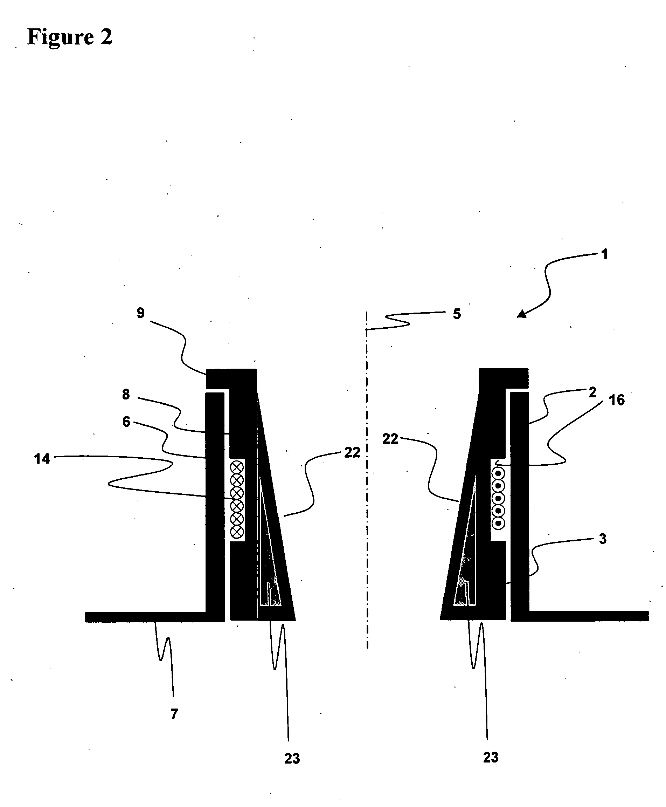

In figure 2 a schematic view of the interior of another embodiment of the implantable chamber according to the present invention is shown, the implantable chamber containing a marker.

The symmetrical implantable chamber 1 (symmetry line 5) is shown without cap. It includes a connecting element 2 and an insert element 3. The connecting element 2 comprises a connecting sleeve 6 and a surrounding contact surface 7. The insert element 3 comprises an insert sleeve 8 and a surrounding abutment surface 9. The insert sleeve 8 is inserted into the connecting sleeve 6 of the connecting element 2. The implantable chamber 1 contains a passive resonance circuit 14 in a recess 16 of the insert sleeve 8. The insert sleeve 8 further includes a marker 22 with a wedge structure, which contains a hollow space 23 filled with liquid for positive contrast. The liquid of the marker 22 can be imaged by an imaging system, which allows the alignment of the implantable chamber 1 within the imaging system.

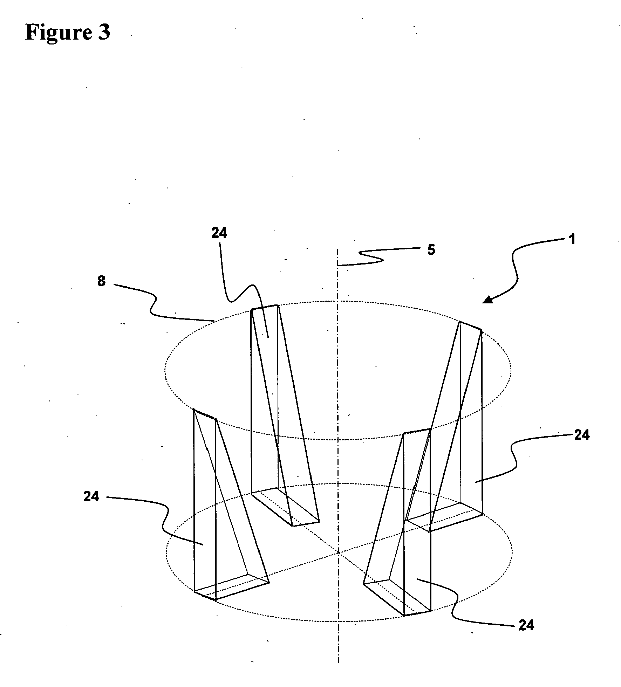

Figure 3 shows a schematic 3D-view of the interior of another embodiment of the implantable chamber according to the present invention, the implantable chamber containing a marker.

The circles in figure 3 indicate the outlines of the insert sleeve 8 of the implantable chamber 1, which is symmetrical referring to a symmetry line 5. The shown embodiment of the implantable chamber 1 contains four wedge structures 24, which are used as a marker 22 in order to allow the alignment of the implantable chamber 1 within an imaging system. The wedge structures 24 do not need to be filled with a signal carrier (e.g. a liquid), since the signal void created by the wedge structures 24 can also be used for the alignment. However, the wedge structures 24 can be filled with a liquid serving as a signal carrier to get a better imaging contrast. The number of the wedge structures 24 can also be varied.

### Example 1

A commercial implantable chamber (model 30268, silicon culture F2U, Renner GmbH, Dannstadt) was provided with a resonance circuit. The resonance circuit was tuned to the resonance frequency of a 1.5 Tesla whole body magnetic resonance tomograph (63.68 MHz). The resonance circuit consisted of a coil made of isolated copper wire, the wire having a diameter of 80 µm. The coil had 15 windings, which were wound coaxially around the insert element of the chamber. The diameter of the windings was 10.25 mm. In order to achieve a fine tuning of the resonance circuit, the isolated ends of the wire were twisted in such a way, that a maximum absorption of the radio frequency radiation was absorbed at the resonance frequency.

A syringe filled with a 1 % by volume solution of Gd-DTPA (magnetic resonance imaging contrast medium) and with water was placed inside of the chamber. The contrast medium was delivered by the German company Schering and named "Magnevist". In a 1.5 Tesla whole body magnetic resonance tomograph (Siemens Magnetom Symphony) the magnetic resonance signal of the syringe was detected (sequence: 2D FLASH, TR = 31 ms, TE = 13.4 ms, slice thickness = 3mm, FOV = 50 mm, matrix = 512 x 512, flip angle = 20°, acquisition time = 16 s). The magnetic resonance signal was detected with a special receiving coil (Flex Loop Small). The same syringe was placed in a small loop radiofrequency coil and was examined under the same conditions. The image of the syringe produced by the measurement using the chamber with the resonance circuit had a signal to noise ratio, which was nearly four times higher than the signal to noise ratio of the image of the syringe in the loop coil.

### Reference numbers

- 1: implantable chamber
- 2: connecting element
- 3: insert element
- 4: cap
- 5: symmetry line
- 6: connecting sleeve
- 7: contact surface
- 8: insert sleeve
- 9: abutment surface
- 10: upper part of the cap
- 11: surrounding edge
- 12: one end of the connecting sleeve
- 13: opening
- 14: resonance circuit
- 15: cavity
- 16: recess
- 17: skin
- 18: object
- 19: separating layer
- 20: further layer
- 21: tissue
- 22: marker
- 23: hollow space
- 24: wedge structures

## Claims

1. Implantable chamber (1) with a connecting element (2), comprising a connecting sleeve (6) and a surrounding contact surface (7), an insert element (3), comprising an insert sleeve (8) and a surrounding abutment surface (9), the insert sleeve (8) being inserted into the connecting sleeve (6) of the connecting element (2), and a cap (4) with a surrounding edge (11), the cap (4) partly covering the connecting element (2) and the insert element (3), leaving an opening (13) on one side, wherein the implantable chamber (1) contains a passive resonance circuit (14) with an inductance and a capacitance, the passive resonance circuit (14) surrounding at least part of a cavity (15) inside the insert element (3).

2. Implantable chamber (1) as claimed in claim 1, wherein the abutment surface (9) of the inserted insert element (3) abuts one end (12) of the connecting sleeve (6) of the connecting element (2) and the surrounding edge (11) of the cap (4) abuts the contact surface (7) of the covered connecting element (2).

3. Implantable chamber (1) as claimed in claim 1 or 2, wherein the opening (13) merges into the cavity (15) within the insert sleeve (8) of the insert element (3).

4. Implantable chamber (1) as claimed in any of claims 1 to 3, containing a removable cover element to cover the opening.

5. Implantable chamber (1) as claimed in claim 4, wherein the cover element is a flexible foil, being secured between the connecting sleeve (6) and the insert sleeve (8).

6. Implantable chamber (1) as claimed in any of claims 1 to 5, wherein the cap (4) is at least partly transparent.

7. Implantable chamber (1) as claimed in any of claims 1 to 6, wherein the cap (4) has an upper area which is flat or curved.

8. Implantable chamber as claimed in any of claims 1 to 7, wherein the inductance is a coil, which is wound around the insert sleeve (8) or the connecting sleeve (6).

9. Implantable chamber (1) as claimed in claim 8, wherein the coil is a flexible printed circuit.

10. Implantable chamber (1) as claimed in claim 8 or 9, wherein the capacitance is a capacitor attached to the coil or is the capacitance of the coil itself.

11. Implantable chamber (1) as claimed in any of claims 1 to 10, wherein the capacitance and the inductance are placed in a recess (16) within the insert sleeve (8), the connecting sleeve (6) or the cap (4).

12. Implantable chamber (1) as claimed in any of claims 1 to 11, comprising at least one marker (22), which can be imaged by an imaging system and which allows the alignment of the chamber (1) within the imaging system.

13. Implantable chamber (1) as claimed in claim 12, the marker (22) being a hollow space (23) filled with a liquid or an appendix of the connecting element (2) or of the insert element (3).

14. Implantable chamber (1) as claimed in any of claims 1 to 13, comprising a fastener for immobilizing the chamber (1) during an application of an imaging method.

15. Implantable chamber (1) as claimed in any of claims 1 to 14, wherein the cavity (15) inside the insert sleeve (8) contains an object (18), the object (18) comprising a separating layer (19) of a medium, which covers the opening (13) of the cavity (15) and at least one further layer (20) of biological material.

16. Imaging method for the imaging of an object (18) inside of an implantable chamber (1) as claimed in any of claims 1 to 15, the chamber (1) containing a passive resonance circuit (14) with a resonance frequency, the method comprising the steps of
- producing and detecting magnetic resonance signals by
• placing the chamber (1) within a magnetic field and by
• applying high frequency radiation with a frequency being essentially equal to the resonance frequency of the passive resonance circuit (14), and
- reconstructing an image of the object (18) from the detected magnetic resonance signals.

17. Imaging method as claimed in claim 16, combining magnetic resonance imaging with an optical imaging method for imaging the object (18).

18. Imaging method as claimed in claim 16 or claim 17, wherein the chamber (1) is implanted at least partly under the skin (17) of an animal and the object (18) inside of the chamber (1) is imaged by successively taking several images with certain time gaps in between the taking of the images.

19. Imaging method as claimed in claim 18, wherein the chamber (1) is aligned for using at least one marker, which is integrated into the chamber (1), in order to assure an unchanged alignment of the object (18) for each of the several images.

20. Imaging method as claimed in any of claims 16 to 19, wherein several objects (18), each of which is placed within a chamber (1), are imaged simultaneously, each chamber (1) being implanted at least partly under the skin (17) of a different animal.

21. Magnetic resonance imaging system comprising
• at least two implantable chambers (1) as claimed in any of claims 1 to 15 and
• a magnetic resonance imaging apparatus, including an electromagnet to produce a uniform static magnetic field, a gradient coil arrangement, whereby a gradient may be imposed on the static magnetic field, a radio frequency coil system with a transmitting coil arrangement to apply a radio frequency field to the chambers (1) to be imaged and with a radio frequency receiving coil arrangement, arranged to detect radio frequency signals resulting from magnetic resonance excited in the object (18) within the chambers, the receiving coil arrangement comprising at least one receiving coil for each chamber (1), being aligned for receiving the radio frequency signals resulting from the object (18) within this chamber (1).

22. Magnetic resonance imaging system as claimed in claim 21, wherein the receiving coils are aligned with the chambers (1) by at least one fixing element which is connected to the receiving coils and to the chambers (1).
